# EUROPEAN PATENT APPLICATION

(11) **EP 1 458 071 A1**
(43) Date of publication of application: **15.09.2004**
(21) Application number: 03251492.9
(22) Date of filing: 12.03.2003
(51) Int. Cl.: H01S 5/16

(54) **Semiconductor laser device**

(71) Applicant: Agilent Technologies, Inc. - a Delaware corporation -, Palo Alto, CA 94303-0870 (US)
(72) Inventor: Hogg, Richard, Ipswich IP1 5PB (US)
(74) Representative: Coker, David Graeme

(57) **Abstract**

The active region of a semiconductor laser device can be formed by depositing one or more regions of material that inhibit the deposition of semiconductor material in order to form a growth area. By depositing semiconductor material, additional depths of semiconductor material will be deposited over the growth area, leading to the formation of thicker MQW layers, which give rise to decreased absorption energies when compared with regions of the semiconductor laser device outside of the growth area. This can be used as the basis for the active region of a semiconductor laser device.

## Description

The present invention relates to semiconductor laser devices and in particular to semiconductor laser devices comprising regions of selective growth.

It is well known that selective growth of epitaxial layers can be achieved using MOVPE (Metallo-Organic Vapour Phase Epitaxy) techniques by first depositing regions of silica. The subsequently deposited epitaxial layers will not form on the silica regions but instead form in the areas adjacent to the silica regions. A general discussion of selective area growth techniques can be found in *'Selective-area low-pressure MOCVD of GaInAsP and related materials on planar InP substrates'* by M Gibbon *et al,* Semiconductor Science Technology 8 (1993) pp 998-1010.

Japanese Patent Application 61 125 910 discloses a technique wherein a silica mask region is deposited and then a laser structure is formed so as to be perpendicular to the silica. The effect of the silica mask is to provide an etch stop for the formation of two additional facets in the centre of the laser chip, such that a cleaved coupled cavity laser can be formed.

According to a first aspect of the present invention there is provided a method of manufacturing a semiconductor laser device, the method comprising the steps of: (a) selectively depositing one or more regions of an inhibiting material on a surface, the inhibiting material reducing the deposition of semiconductor material onto a surface, the or each regions of inhibiting material defining a growth area; (b) depositing semiconductor material onto the surface and the regions of inhibiting material; the method being characterised in that during step (b) the semiconductor material is deposited selectively on the growth area.

The selective deposition of semiconductor material on the growth area causes the thickness of deposited semiconductor material to be increased (if MQW structures are being formed then the layers will also be thicker). This leads to a decrease in the absorption energy when compared with the absorption energy of the semiconductor material deposited elsewhere on the surface. This results in an abrupt transition between the decreased absorption energy associated with the growth area and the higher absorption energy associated with the other regions. By forming the laser facets in regions of high absorption energy, the facets act as non-absorbing mirrors that define a laser structure.

Known techniques for forming non-absorbing mirrors within semiconductor structures tend to involve processes that cause defects to be introduced into the semiconductor structure, for example intermixing via, for example, the implantation of other dopants into the semiconductor structure or by selectively etching and then re-growing the structure. The introduction of these defects gives rise to potential points of failure which will reduce the reliability of such devices. Furthermore, the present invention enables the formation of non-absorbing mirrors using fewer process steps, that should lead to increased yield and reliability.

The one or more regions of inhibiting material may comprise two substantially rectangular regions and the growth area may comprise a substantially rectangular area, formed between the two regions of inhibiting material.

The selective deposition of semiconductor material on the growth area may form the active region of the semiconductor laser device. The semiconductor material deposited during step (b) may comprise alternating layers of different semiconductor materials. The one or more regions of an inhibiting material and the semiconductor material may be deposited onto a semiconductor substrate or alternatively they may be deposited onto a buffer layer formed on a semiconductor substrate. The laser facets must then be formed in a region of high absorption energy.

The method may further comprise the steps of: (c) removing the one or more regions of an inhibiting material; (d) selectively removing semiconductor material and depositing semiconductor material to form a waveguide; and (e) depositing additional semiconductor material over the surface and the growth area. The method may also further comprise the step of: (f) selectively removing semiconductor material to provide a planar surface.

According to a second aspect of the present invention there is provided a semiconductor laser device made according to any of the methods described above with reference to the first aspect of the present invention.

The invention will now be described, by way of example only, with reference to the following Figures in which:
Figure 1 shows a schematic depiction of a plan view of a semiconductor laser device according to the present invention;
Figure 2 shows a schematic depiction of a cross-sectional view through the semiconductor laser device shown in Figure 1 and shows the variation in semiconductor material thickness across the device;
Figure 3 shows a graphical depiction of the variation of absorption energy within the semiconductor laser device;
Figure 4 shows a schematic partial depiction of a cross-section of a semiconductor laser device according to the present invention; and
Figure 5 shows a schematic depiction of the silica patterning deposited during the formation of a laser device according to the present invention.

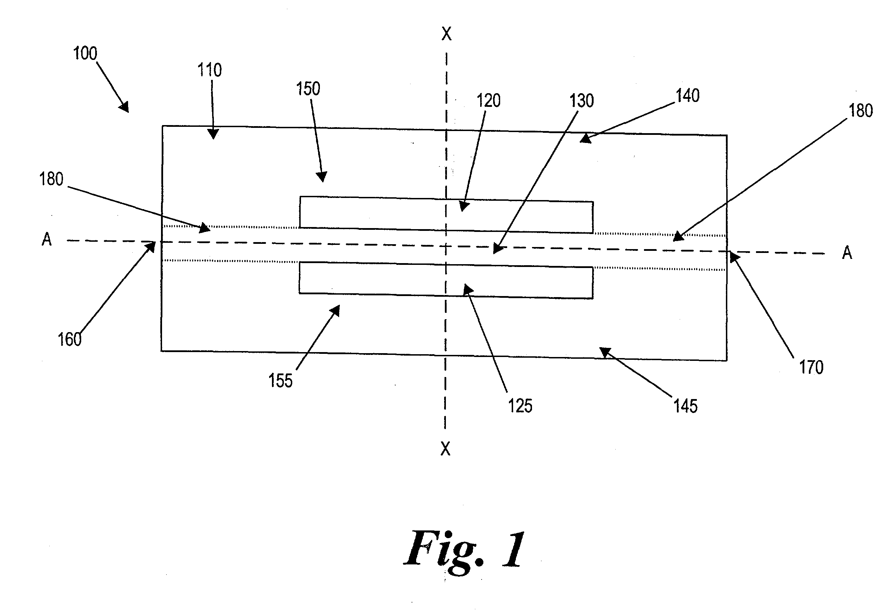

Figure 1 shows a schematic depiction of a plan view of a semiconductor laser device according to the present invention. The semiconductor laser device 100 comprises planar substrate 110 upon which two regions of silica 120, 125 have been deposited using conventional techniques. Subsequently, epitaxial layers of III-V semiconductor material are deposited onto the planar substrate and the silica regions. Typically, alternating layers of different semiconductor materials, for example gallium arsenide (GaAs) and indium gallium arsenide (InGaAs) are deposited in order to form multi quantum well (MQW) material. It is well known to use MQW material in order to form the active regions of optical transmitters.

As is known, the presence of the silica inhibits the semiconductor material from being deposited upon the silica regions. The effect of this is that the semiconductor material is deposited to a greater depth in the areas immediately adjacent to the silica.

The central region 130, which is located inbetween the two silica regions 120, 125, will experience the deepest growth of semiconductor material, as semiconductor material will form in the central region rather than on either of the silica regions. The width of the silica regions and their separation (and thus the width of the central region) will determine the additional thickness of semiconductor material that is deposited in the central region 130. Regions 150 and 155, which are adjacent to one of the silica regions will experience some additional growth of semiconductor material, but not to the same extent as the central region, as the regions 150, 155 are adjacent to only one of the silica regions. As the distance from the silica region increase, the additional depth of semiconductor material will decrease. Peripheral regions 140 and 145 are relatively remote from the silica regions and will thus experience no significant additional growth of semiconductor material. The device must be cleaved such that the laser facets are in regions having insignificant additional growth of semiconductor material, that is where the absorption energy is highest. Figure 1 shows the position of the facets 160, 170 for the present semiconductor laser device.

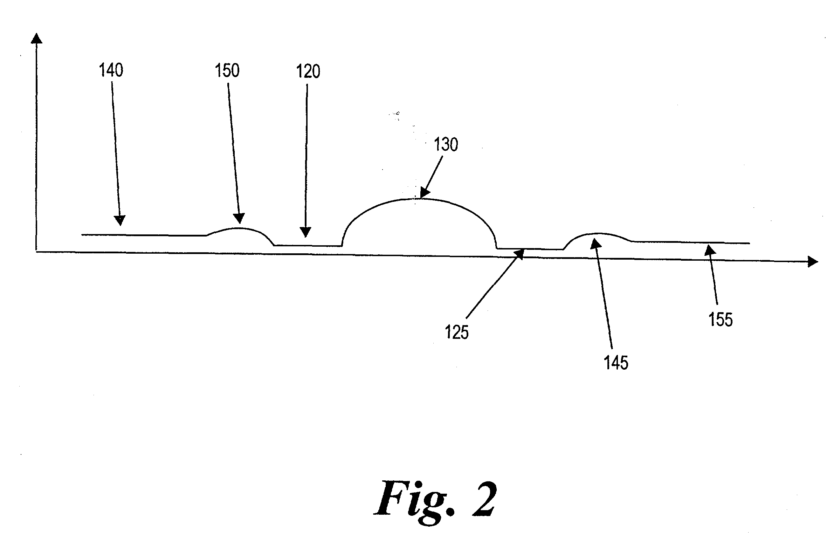

Figure 2 shows a schematic depiction of a cross-sectional view through the semiconductor laser device shown in Figure 1 and shows the variation in semiconductor material thickness across the device. The cross-section shown is taken through line X-X. The different regions of the device are indicated by their respective reference numeral.

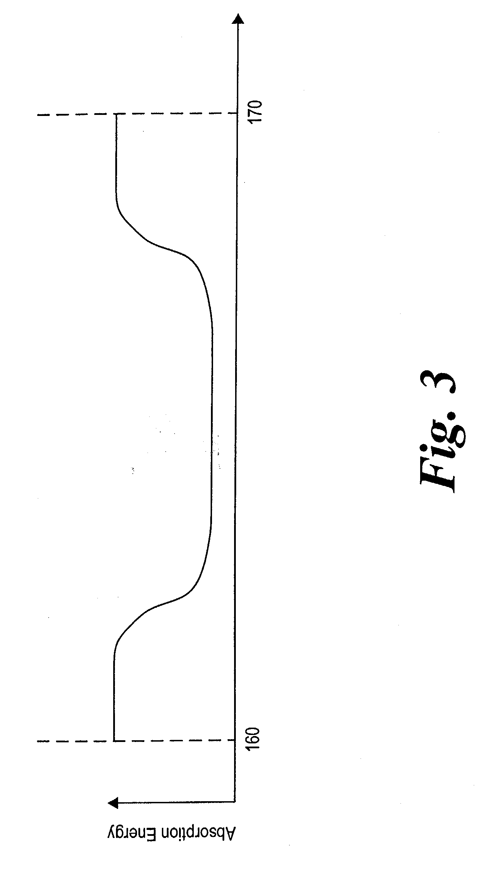

Although Figure 2 indicates that the silica regions 120, 125 experience a limited deposition of semiconductor material, this will only occur if errors are made in the handling and the processing of the substrate. The graph in Figure 3 should be interpreted to indicate a baseline level of semiconductor material growth on the silica regions in order to make comparisons with the other regions of the device.

Figure 2 shows that there is limited deposition of semiconductor material on the peripheral regions 140, 145. There is a greater degree of semiconductor material growth in the regions 150,155 next to the silica regions, with most growth occurring immediately next to the silica regions. The greatest deposition of semiconductor material occurs in the central region 130, due to the combined effect of the two silica regions. If the semiconductor material is being applied as alternate layers of different materials then each layer will have a similar profile (i.e. no (or negligible) semiconductor material growth on the silica regions and deepest growth of semiconductor material in the central region).

The effect of deepening the layers within an MQW structure is to cause the absorption energy of the MQW structure to decrease, as the quantum confinement energy within the MQW structure decreases. Figure 3 shows the variation of absorption energy along the line A-A that is shown in Figure 1, which is perpendicular to line X-X. The area 130 between the silica regions 120, 125 has a lowered absorption energy whilst the regions 140, 145 have the conventional absorption energy (and electronic structure) for that semiconductor material. The regions of higher absorption energy region constitute non-absorbing mirrors that can be used to define the cavity of a laser device. The position of the laser facets 160, 170 are also indicated on Figure 3.

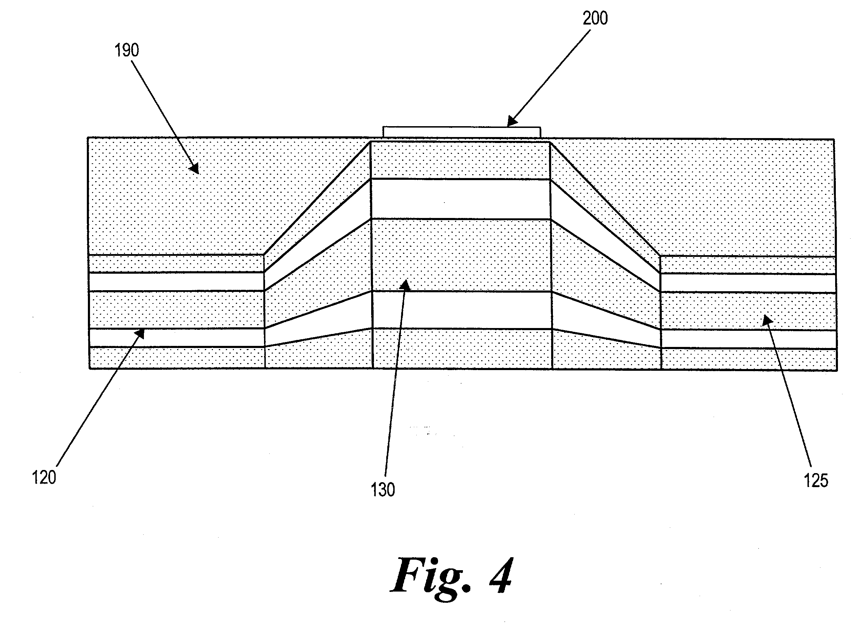

In order to facilitate the commercial production of the semiconductor laser device, it is preferred to cleave the device appropriately, and to deposit additional semiconductor material (in bulk, rather than in layers to from MQW material) to planarise the top surface of the device, thus assisting in the formation of electrical contacts on the device. Figure 4 shows a schematic partial depiction of a cross-section of a semiconductor laser device according to the present invention in which additional semiconductor material 190 is deposited upon the selectively grown active region 130 and the regions 120, 125 that formerly inhibited the deposition of semiconductor materials. One or more electrical contacts 200 may be provided on the upper surface of the additional semiconductor material 190 to enable the operation of the semiconductor laser device. Although not shown in Figure 4, the additional semiconductor material 190 will typically extend across the full width of the semiconductor laser device. It may be necessary to remove the silica regions in order to deposit semiconductor material over them, and additional masking and etching processes and/or some form of mechanical polishing may be used to form the desired planar surface. Prior to the planarisation of the device, it may be selectively etched and further semiconductor material selectively deposited in order to form a waveguide structure. The position of such a waveguide structure 180 is shown in Figure 1 and serves to assist the propagation of light from the active region to the facets of the laser.

A specific example of a semiconductor laser device according to the present invention will now be described. Conventional MOVPE equipment and techniques are used, with a growth temperature of 700°C (except for the formation of the QW material [layer 6 in Table 1 below] which is grown at approximately 600°C). Standard precursor materials are used (that is trimethylgallium, trimethylaluminium and trimethylindium) at a pressure of 200mbar and with a III-V ratio of 150. Table 1 describes the order and the composition of the layers deposited on an n-doped gallium arsenide substrate.

**Table 1 -**

| Layer Compositions | | | |
|---|---|---|---|
| Layer | Material | Thickness | Doping |
| 1 | GaAs | 1 µm | n type, ∼3 x 10¹⁸ |
| 2 | GaAs | ∼100nm | n type,∼5 x 10¹⁸ |
| 3 | Al_{0.6}Ga_{0.4}As | 1µm | n type,∼1 x 10¹⁸ |
| 4 | Graded AlGaAs Al% 60% to 0% | 150nm | n type,∼1 x 10¹⁷ |
| 5 | GaAs | 10nm | un-doped |
| 6 | In_{0.2}Ga_{0.8}As/GaAs MQW | 2x ∼ 8nm/10nm | un-doped |
| 7 | GaAs | 10nm | un-doped |
| 8 | Graded AlGaAs Al% 0% to 60% | 150nm | p type, ∼1 x 10¹⁷ |
| 9 | Al_{0.6}Ga_{0.4}As | 1µm | p type,∼1 x 10¹⁸ |
| 10 | GaAs | 200nm | p type, ∼1 x 10¹⁹ |

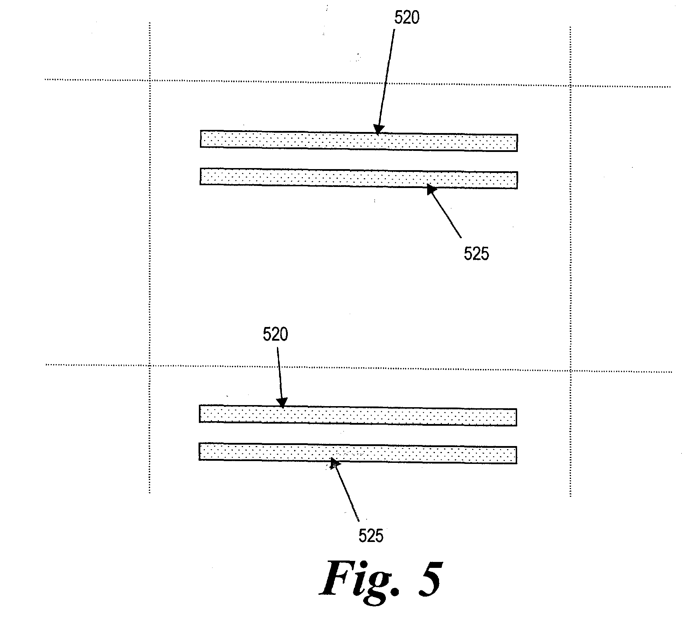

After layer 1 has been deposited the wafer is removed from the growth reactor in order that the wafer can be patterned in silica as shown in Figure 5. The silica regions 520, 525 are approximately 600*µ*m in length and 50µm wide. The distance between two adjacent silica regions, and thus the width of the growth area defined therein between, is approximately 30µm. It is preferred that each pair of silica regions is separated from the adjacent pair of silica regions by at least 200µm in order to facilitate the cleaving of the devices (the dotted lines in Figure 5 indicate the cleaves that would be made to define the devices).

After the wafer has been patterned then it is returned to the growth reactor and the subsequent layers formed. In this case the laser is intended to transmit at 980 nm and thus the InGaAs MQW width and composition are tuned to give 980 nm emission in the active region of the laser. Once all of the layers have been formed then the silica patterning may be stripped and the wafer returned to the growth kit to planarise the structure by growing more AlGaAs and/or GaAs.

Once the structure has been planarised then it is possible to form a broad area laser by depositing a thin metal stripe along the length of the laser's active region for contact to p doped semiconductor. Alternatively, a ridge-waveguide laser can be formed by defining a 2-3 µm wide strip in the centre of mask region and etching epitaxial semiconductor outside this etch mask. As a further alternative a buried heterostructure could be formed by one of a number of known techniques.

It has been found that the non-absorbing mirror region typically is typically approximately 30-50% smaller than the growth area of the laser. Although the above method describes the silica patterning being defined in between steps 1 and 2, and then being removed after the formation of the device, but before any device planarisation, it should be understood that the silica patenting may be applied at any stage prior to the growth of the QW material and then removed at any time after the growth of the QW material.

It should be understood that the use of two regions of inhibiting material, as described above, is not essential to the present invention. The advantage of using two regions that are spaced apart so as to define a growth area is that there is a synergistic effect due to the material that is inhibited from forming on either region being deposited on the growth area. If only one region of inhibiting material is formed, then the additional thickness of semiconductor material in the growth area will not be as thick, leading to a less pronounced change in the absorption energy. More complex growth area structures may be defined using three or more regions of inhibiting material, as desired.

The invention is believed to be compatible with all semiconductor laser structures. If the semiconductor laser structure incorporates a grating element, for example, as with a distributed feedback (DFB) laser, then it is essential that the structure of the grating is not effected by the selective growth of semiconductor material in order to form the active region of the device.

It will be understood that the laser structure according to the present invention may be deposited directly onto a substrate formed from a semiconductor material, or that one or more buffer layers may be provided between the substrate and the laser structure. Furthermore, one or more buffer layers may be provided between the laser structure and the semiconductor material used in providing a planar surface to the device.

It is believed that the invention is suitable for use with a range of II-VI or III-V materials systems, for example AlGaInAsP on GaAs substrates (as are commonly used to make 980nm pump lasers) or AlGaInAsP on InP substrates (which are used to make 1300nm and 1550 nm devices). It also understood that chemical beam Epitaxy (CBE) may be used to fabricate semiconductor laser devices according to the present invention.

It will also be understood that other materials other than silica may be used to inhibit the deposition of semiconductor material. Other materials that may be used include, without limitation, silicon nitride (Si₃N₄), aluminium oxide (Al₂O₃) or aluminium nitride (AlN).

## Claims

1. A method of manufacturing a semiconductor laser device (100), the method comprising the steps of:
(a) selectively depositing one or more regions (120, 125) of an inhibiting material on a surface (110), the inhibiting material reducing the deposition of semiconductor material onto a surface, the one or more regions of inhibiting material defining a growth area (130);
(b) depositing semiconductor material onto the surface and the or each region of inhibiting material;
the method being **characterised in that** during step (b) the semiconductor material is deposited selectively on the growth area.

2. A method according to claim 1, wherein the one or more regions of inhibiting material (120, 125) comprise two substantially rectangular regions and the growth area (130) comprises a substantially rectangular area, formed between the two regions of inhibiting material.

3. A method according to claim 1 or claim 2, wherein the selective deposition of semiconductor material on the growth area (130) forms the active region of the semiconductor laser device.

4. A method according to any preceding claim, wherein the semiconductor material deposited during step (b) comprises alternating layers of different semiconductor materials.

5. A method according to any preceding claim, wherein the one or more regions of an inhibiting material and the semiconductor material are deposited onto a semiconductor substrate.

6. A method according to any of claims 1 to 4, wherein the one or more regions of an inhibiting material and the semiconductor material are deposited onto a buffer layer formed on a semiconductor substrate.

7. A method according to any preceding claim, the method further comprising the steps of:
(c) removing the one or more regions of an inhibiting material (120, 125);
(d) selectively removing semiconductor material and depositing semiconductor material to form a waveguide (180); and
(e) depositing additional semiconductor material (190) over the surface and the growth area.

8. A method according to claim 7, the method further comprising the step of:
(f) selectively removing semiconductor material to provide a planar surface.

9. A semiconductor laser device made according to the method of any of claims 1 to 8.
